(19) Europäisches Patentamt / European Patent Office / Office européen des brevets

(11) **EP 4 647 792 A1**

(12) **EUROPEAN PATENT APPLICATION**
published in accordance with Art. 153(4) EPC

(43) Date of publication:
**12.11.2025 Bulletin 2025/46**

(21) Application number: **24882630.7**

(22) Date of filing: **02.09.2024**

(51) International Patent Classification (IPC):
$G01R\ 31/66^{(2020.01)}$    $G01R\ 27/20^{(2006.01)}$
$G01R\ 19/10^{(2006.01)}$    $G01R\ 27/08^{(2006.01)}$
$B60L\ 3/00^{(2019.01)}$    $B60L\ 53/80^{(2019.01)}$

(52) Cooperative Patent Classification (CPC):
**B60L 3/00; B60L 53/80; G01R 19/10; G01R 27/08;**
**G01R 27/20; G01R 31/66**

(86) International application number:
**PCT/KR2024/013131**

(87) International publication number:
**WO 2025/089601 (01.05.2025 Gazette 2025/18)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **26.10.2023 KR 20230144699**

(71) Applicant: **LG Energy Solution, Ltd.**
**Seoul 07335 (KR)**

(72) Inventors:
• **KIM, Jun Suk**
  **Daejeon 34122 (KR)**
• **AN, Hyo Seong**
  **Daejeon 34122 (KR)**

(74) Representative: **Plasseraud IP**
**104 Rue de Richelieu**
**CS92104**
**75080 Paris Cedex 02 (FR)**

(54) **CONTACT RESISTANCE ABNORMALITY DIAGNOSIS METHOD AND CONTACT RESISTANCE ABNORMALITY DIAGNOSIS SYSTEM**

(57) The present disclosure relates to a contact resistance abnormality diagnosis method and a contact resistance abnormality diagnosis system. The contact resistance abnormality diagnosis method includes, when a battery connector of a battery pack is coupled to a plurality of system connectors of a plurality of battery swapping systems (BSSs) by a first connector assembly at a plurality of first time points, receiving a plurality of first contact resistance values for the first connector assembly corresponding to the plurality of first time points from the plurality of BSSs, when the battery connector is connected to a plurality of vehicle connectors of a plurality of vehicles at a plurality of second time points as a second connector assembly, receiving a plurality of second contact resistance values for a second connector assembly corresponding to the plurality of second time points from the plurality of vehicles, arranging, by a central server, the plurality of first and second contact resistance values in an order of time of the plurality of first and second time points to generate a log table., and determining states of the battery connector, the plurality of system connectors, and the plurality of vehicle connectors based on the log table.

**(Cont. next page)**

EP 4 647 792 A1

【Figure 1】

**Description**

**[Technical Field]**

CROSS-REFERENCE TO RELATED APPLICATION

This application claims priority to and the benefit of Korean Patent Application No. 10-2023-0144699 filed in the Korean Intellectual Property Office on October 26, 2023, the entire contents of which are incorporated herein by reference.

The present disclosure relates to a contact resistance abnormality diagnosis method and a contact resistance abnormality diagnosis system.

**[Background Art]**

A swappable battery pack charged through a battery swapping system/station (BSS) is attached and detached between a plurality of BSSs and a plurality of vehicles multiple times due to characteristics of a use environment. Due to the detachment and attachment from various devices multiple times, fatigue may be accumulated in the connector of the battery pack or foreign matters may occur in the connector.

When the contact resistance of the connector increases due to deformation caused by the accumulated fatigue of the connector, the foreign matter jamming, etc., the performance of the battery pack may deteriorate during charging and discharging of the battery pack.

**[Disclosure]**

**[Technical Problem]**

The present disclosure attempts to provide a contact resistance abnormality diagnosis method and a contact resistance abnormality diagnosis system for diagnosing the occurrence of abnormalities in connectors provided in a battery pack, a BSS, and a vehicle, respectively, by monitoring the contact resistance of the connector between the battery pack and the BSS and the contact resistance of the connector between the battery pack and the vehicle for a swappable battery pack.

**[Technical Solution]**

According to an aspect of the present disclosure, a contact resistance abnormality diagnosis method performed by allowing a processor to execute a connector contact abnormality diagnosis program stored in a memory includes when a battery connector of a battery pack is coupled to a plurality of system connectors of a plurality of battery swapping systems (BSSs) by a first connector assembly at a plurality of first time points, receiving, by a central server, a plurality of first contact resistance values for the first connector assembly corresponding to the plurality of first time points from the plurality of BSSs, when the battery connector is connected to a plurality of vehicle connectors of a plurality of vehicles at a plurality of second time points by a second connector assembly, receiving, by the central server, a plurality of second contact resistance values for a second connector assembly corresponding to the plurality of second time points from the plurality of vehicles, arranging, by the central server, the plurality of first contact resistance values and the plurality of second contact resistance values in an order of time of the plurality of first time points and the plurality of second time points to generate a log table, and determining states of the battery connector, the plurality of system connectors, and the plurality of vehicle connectors based on the log table.

The contact resistance abnormality diagnosis method may further include transmitting a diagnosis result indicating the states of the battery connector, the plurality of system connectors, and the plurality of vehicle connectors to a user terminal.

Each of the plurality of first contact resistance values may be a value derived by dividing a difference between a positive terminal voltage of the battery connector and a positive terminal voltage of the corresponding system connector among the plurality of system connectors by a charging current of the battery pack, at each of the plurality of first time points.

Each of the plurality of second contact resistance values may be a value derived by dividing a difference between the positive terminal voltage of the battery connector and the positive terminal voltage of the corresponding system connector among the plurality of vehicle connectors by a discharging current of the battery pack, at each of the plurality of second time points.

The contact resistance abnormality diagnosis method may further include, when a second resistance value immediately after a first resistance value exceeding a predetermined upper threshold value among the plurality of first contact resistance values and the plurality of second contact resistance values is smaller than the first resistance value, determining a state of a system connector corresponding to the first resistance value or a vehicle connector corresponding to the first resistance value among the plurality of system connectors and the plurality of vehicle connectors as an abnormal state.

The contact resistance abnormality diagnosis method may further include, when contact resistance values that continuously exceed a predetermined upper threshold value among the plurality of first contact resistance values and the plurality of second contact resistance values are a predetermined number or more, determining the state of the battery connector as an abnormal state.

The contact resistance abnormality diagnosis method may further include, when a slope between two contact resistance values at two adjacent time points among the plurality of first contact resistance values and the plurality of second contact resistance values is continuously greater than or equal to a predetermined threshold slope, determining the state of the battery connector as an abnormal state.

According to another aspect of the present disclosure, a contact resistance abnormality diagnosis system includes a memory that stores a connector contact abnormality diagnosis program for a swappable battery pack, a processor that executes the connector contact abnormality diagnosis program to determine states of a battery connector of the battery pack, a plurality of system connectors of a plurality of battery swapping systems (BSSs), and a plurality of vehicle connectors of a plurality of vehicles, and when the battery connector is connected to the system connectors of each of the plurality of BSSs by a first connector assembly at a plurality of first time points, a communication unit that receives a plurality of first contact resistance values for the first connector assembly corresponding to the plurality of first time points from the plurality of BSSs, and when the battery connector is connected to the vehicle connectors of each of the plurality of vehicles by a second connector assembly at a plurality of second time points, receives a plurality of second contact resistance values for the second connector assembly corresponding to the plurality of second time points from the plurality of vehicles, in which the processor arranges the plurality of first contact resistance values and the plurality of second contact resistance values in an order of time of the plurality of first time points and the plurality of second time points to generate a log table, and determines the states of the battery connector, the plurality of system connectors, and the plurality of vehicle connectors based on the log table.

The communication unit may transmit a diagnosis result indicating the states of the battery connector, the plurality of system connectors, and the plurality of vehicle connectors to a user terminal.

The battery pack may derive a contact resistance value corresponding to the plurality of first contact resistance values by dividing a difference between a positive terminal voltage of the battery connector and a positive terminal voltage of the corresponding system connector among the plurality of system connectors at each of the plurality of first time points by a charging current of the battery pack.

The battery pack may derive a contact resistance value corresponding to the plurality of second contact resistance values by dividing a difference between a positive terminal voltage of the battery connector and a positive terminal voltage of the corresponding vehicle connector among the plurality of vehicle connectors at each of the plurality of second time points by a discharging current of the battery pack.

When a second resistance value immediately after a first resistance value exceeding a predetermined upper threshold value among the plurality of first contact resistance values and the plurality of second contact resistance values is smaller than the first resistance value, the processor may determine a state of a system connector corresponding to the first resistance value or a vehicle connector corresponding to the first resistance value among the plurality of system connectors and the plurality of vehicle connectors as an abnormal state.

When contact resistance values that continuously exceed a predetermined upper threshold value among the plurality of first contact resistance values and the plurality of second contact resistance values are a predetermined number or more, the processor may determine the state of the battery connector as an abnormal state.

When a slope between two contact resistance values at two adjacent time points among the plurality of first contact resistance values and the plurality of second contact resistance values is continuously greater than or equal to a predetermined threshold slope, the processor may determine the state of the battery connector as an abnormal state.

**[Advantageous Effects]**

According to the present disclosure, by detecting a change in contact resistance between connectors of a swappable battery pack, it is possible to smooth the current flow during charging and discharging of the battery pack and improve the lifespan of the battery pack.

According to the present disclosure, it is possible to prevent the risk of difficulty in using the battery pack due to the occurrence of a connector contact abnormality in advance.

According to the present disclosure, by repairing the connector before a problem occurs in the operation of a BSS, a vehicle, etc., to which the swappable battery pack may be connected, it is possible to improve the convenience of management and reduce costs in the BSS, the vehicle, etc.

According to the present disclosure, it is possible to increase the usability of the swappable battery pack through the management of the swappable battery pack, the BSS, the vehicle, etc.

**[Description of the Drawings]**

FIG. 1 is a block diagram schematically illustrating a contact abnormality diagnosis system of a swappable battery pack according to an exemplary embodiment.

FIG. 2 is an exemplary diagram illustrating a detailed configuration of a battery connector.

FIG. 3 is an exemplary diagram illustrating a detailed configuration of a system connector or a vehicle connector.

FIG. 4 is a block diagram schematically illustrating a configuration of a battery pack and a BSS illustrated in FIG. 1.

FIG. 5 is a block diagram schematically illustrating an appearance in which the battery pack according to an exemplary embodiment is coupled to the BSS illustrated in FIG. 4.

FIG. 6 is a block diagram illustrating an exemplary embodiment in which one end of the BSS illustrated in FIG. 5 is connected to a system connector.

FIG. 7 is a block diagram schematically illustrating the configuration of the battery pack and the vehicle illustrated in FIG. 1.

FIG. 8 is a block diagram schematically illustrating an appearance in which the battery pack according to an exemplary embodiment is connected to the vehicle illustrated in FIG. 7.

FIG. 9 is a block diagram schematically illustrating an exemplary embodiment in which one end of the vehicle illustrated in FIG. 8 is connected to the vehicle connector.

FIG. 10 is a block diagram schematically illustrating a detailed configuration of a central server illustrated in FIG. 1 and FIGS. 4 to 9.

FIGS. 11, 12, and 13 are examples of graphs represented by log tables according to an exemplary embodiment.

FIG. 14 is a flowchart of a contact resistance abnormality diagnosis method according to an exemplary embodiment.

**[Mode for Invention]**

Hereafter, embodiments of the present disclosure will be described in detail with reference to the accompanying drawings and the same or similar components are given the same reference numerals and are not repeatedly described. The suffix "module" and/or "unit" for components used in the following description is given or mixed in consideration of only the ease of writing of the specification, and therefore, do not have meanings or roles that distinguish from each other in themselves. In addition, when it is determined that a detailed description for the known art related to embodiments disclosed in the present specification may obscure the gist of the embodiments disclosed in present specification, the detailed description will be omitted. Further, it should be understood that the accompanying drawings are provided only in order to allow exemplary embodiments of the present disclosure to be easily understood, and the spirit of the present disclosure is not limited by the accompanying drawings, but includes all the modifications, equivalents, and substitutions included in the spirit and the scope of the present disclosure.

Terms including an ordinal number such as first, second, etc., may be used to describe various components, but the components are not limited to these terms. The above terms are used solely for the purpose of distinguishing one component from another.

It will be further understood that terms "include" or "have" used in the present specification specify the presence of features, numerals, steps, operations, components, parts mentioned in the present specification, or combinations thereof, but do not preclude the presence or addition of one or more other features, numerals, steps, operations, components, parts, or combinations thereof.

Among the components according to an embodiment, a program implemented as a set of instructions specifying a control algorithm necessary for controlling other components may be installed in a component that controls other components under specific control conditions. The control component may process input data and stored data according to installed programs to generate output data. The control component may include a non-volatile memory for storing programs and a memory for storing data.

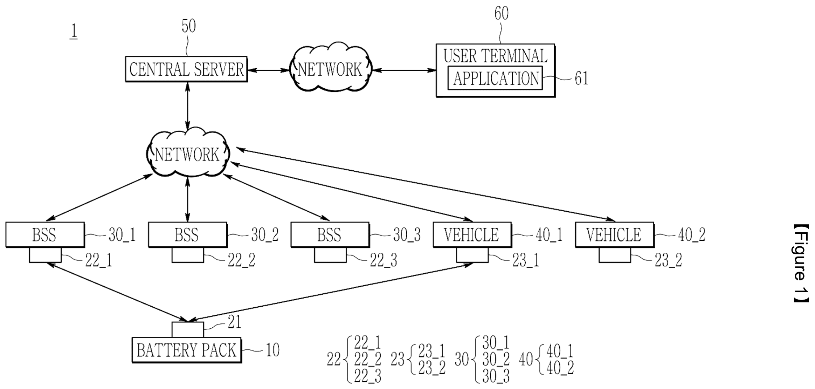

FIG. 1 is a block diagram schematically illustrating a contact abnormality diagnosis system of a swappable battery pack according to an exemplary embodiment.

Referring to FIG. 1, a contact resistance abnormality diagnosis system 1 of a swappable battery pack may include a battery pack 10, a plurality of battery swapping systems (BSS) 30_1 to 30_3, a plurality of vehicles 40_1 and 40_2, a central server 50, and a user terminal 60.

The battery pack 10 may include a battery connector 21. The battery pack 10 is a swappable battery pack, and may be attached and detached between each of the plurality of BSSs 30_1 to 30_3 or between use applications multiple times. Here, the use application may represent battery pack counterparts such as two-wheeled vehicles, carts, or vehicles. For convenience of description, the application of use is assumed to be a vehicle.

The plurality of vehicles 40_1 and 40_2 may be two-wheeled vehicles, vehicles, carts, etc. The battery pack 10 may be attached and detached from each of the plurality of vehicles 40_1 and 40_2 multiple times.

For convenience of description, when describing the common operation and technical features of the plurality of BSSs 30_1 to 30_3, the plurality of BSSs 30_1 to 30_3 are collectively referred to as BSS 30. In FIG. 1, the number of BSSs 30_1 to 30_3 is illustrated as three, but this is for convenience of description and the present disclosure is not limited thereto. The contact resistance abnormality diagnosis system 1 may include two or more BSSs. For convenience of description below, the number of BSSs is assumed to be three.

The BSS 30_1 may include a system connector 22_1, the BSS 30_2 may include a system connector 22_2, and the BSS 30_3 may include a system connector 22_3. Each of the plurality of BSSs 30_1 to 30_3 (e.g., 30_1) may charge the battery pack 10 connected to the corresponding system connector (e.g., 22_1) among the plurality of system connectors 22_1 to 22_3.

For convenience of description below, when describing common operations and technical features of the plurality of system connectors 22_1 to 22_3, the plurality of system connectors 22_1 to 22_3 are collectively referred to as a system connector 22. The system connector 22 may be coupled to and electrically connected to a battery connector 21. The battery connector 21 may be connected to one of the plurality of system connectors 22_1 to 22_3 (e.g., 22_1) to electrically connect the corresponding BSS (e.g., 30_1) among the plurality of BSSs 30_1 to 30_3 to the battery pack 10.

In FIG. 1, for convenience of description, the BSS to which the battery pack 10 is connected among the plurality of BSSs 30_1 to 30_3 is BSS 30_1, and the use application to which the battery pack 10 is connected among the plurality of vehicles 40_1 and 40_2 is a vehicle 40_1, but this is for convenience of description and the present disclosure is not limited thereto.

Hereinafter, for the convenience of description, when describing the common operation and technical features of the plurality of vehicles 40_1 and 40_2, the plurality of vehicles 40_1 and 40_2 are collectively referred to as the vehicle 40. In FIG. 1, the number of vehicles 40_1 and 40_2 is illustrated as 2, but this is for the convenience of description and the present disclosure is not limited thereto. The contact resistance abnormality diagnosis system 1 may include 2 or more vehicles. Hereinafter, for the convenience of description, the number of vehicles is assumed to be 2.

The vehicle 40_1 may include a vehicle connector 23_1, and the vehicle 40_2 may include a vehicle connector 23_2. Each of the plurality of vehicles 40_1 and 40_2 (e.g., 40_1) may discharge the battery pack 10 connected to the corresponding system connector (e.g., 22_1) among the plurality of vehicle connectors 23_1 and 23_2.

Hereinafter, for convenience of description, when describing the common operation and technical features of the plurality of vehicle connectors 23_1 and 23_2, the plurality of vehicle connectors 23_1 and 23_2 are collectively referred to as a vehicle connector 23. The vehicle connector 23 may be coupled to and electrically connected to the battery connector 21. The battery connector 21 may be connected to one of the plurality of vehicle connectors 23_1 and 23_2 (e.g., 23_1) to electrically connect the corresponding vehicle (e.g., 40_1) among the plurality of vehicles 40_1 and 40_2 to the battery pack 10.

The central server 50 may communicate with the BSS 30 and/or the vehicle 40 through a network, and may communicate with the user terminal 60 through the network. Hereinafter, the network may be wired or wireless communication. For example, the network may be LTE communication of the vehicle 10, Ethernet communication of each of the plurality of BSSs 30_1 to 30_3, etc. The central server 50 may receive charging contact resistance information and discharging contact resistance information from the BSS 30 and/or the vehicle 40.

Charging contact resistance information may be a contact resistance of the connector to which the battery pack 10 and the BSS 30 are connected when charging the battery pack 10, and discharging contact resistance information may be a contact resistance of the connector to which the battery pack 10 and the vehicle 40 are connected when discharging the battery pack 10. For example, the central server 50 may receive the charging contact resistance information from the BSS 30_1 and the discharging contact resistance information from the vehicle 40_1.

The battery pack 10 may be connected to each of the plurality of BSSs 30_1 to 30_3 once or more, and may be connected to each of the plurality of vehicles 40_1 and 40_2 once or more. The plurality of BSSs 30_1 to 30_3 may receive the charging contact resistance information from the battery pack 10 corresponding to each mounting time point, and transmit the charging contact resistance information to the central server 50 at any time point within a predetermined time period from the reception point. The plurality of vehicles 40_1 and 40_2 may receive discharging contact resistance information from the battery pack 10 corresponding to each mounting time point, and transmit the discharging contact resistance information to the central server 50 at any time within a predetermined time period from the reception point.

When connected to one of the plurality of BSSs 30_1 to 30_3 (e.g., 30_1), the battery pack 10 may perform a charging operation (hereinafter, "charging operation") using power supplied from the connected BSS (e.g., 30_1). When connected to one of the plurality of vehicles 40_1 and 40_2 (e.g., 40_1), the battery pack 10 may perform a discharging operation (hereinafter, "discharging operation") that supplies power to the connected vehicle (e.g., 40_1). The battery pack 10 may alternately perform a charging operation from one of the plurality of BSSs 30_1 to 30_3 (e.g., 30_1) and a discharging operation to one of the plurality of vehicles 40_1 and 40_2 (e.g., 40_1).

For example, after the discharging operation performed by the battery pack 10 connected to the vehicle 40_1 is terminated, the battery pack 10 is electrically disconnected from the vehicle 40_1 and is electrically connected to the BSS 30_1 to perform the charging operation. After the charging operation performed by the battery pack 10 connected to the BSS 30_1 is terminated, the battery pack 10 is electrically disconnected from the BSS 30_1 and is electrically connected to the vehicle 40_1 to perform the discharging operation again.

In FIG. 1, it is illustrated that the battery pack 10 performs the charging operation through the plurality of BSSs 30_1 to 30_3 and performs the discharging operation through the plurality of vehicles 40_1 and 40_2, but this is for the convenience of description and the present disclosure is not limited thereto. The description of the plurality of BSSs 30_1 to 30_3 below may be applied to a device having a charging device capable of charging the battery pack 10, and the description of the plurality of vehicles 40_1 and 40_2 may be applied to a device having a load that receives power from the battery pack 10.

The battery pack 10 may be deformed due to fatigue accumulation of the connector, foreign matters between the connectors, etc., through plurality of disconnections from and connections to the plurality of BSSs 30_1 to 30_3 and the plurality of vehicles 40_1 and 40_2. The contact resistance abnormality diagnosis system 1 may determine the states of the battery connector 21, the system connector 22, and the vehicle connector 23 based on a contact resistance value of a connector assembly generated by connecting the battery connector 21 to the system connector 22 and a contact resistance value of the connector assembly generated by connecting the battery connector 21 to the vehicle connector 23.

The central server 50 may transmit diagnostic results indicating the states of the determined battery connector 21, the system connector 22, and the vehicle connector 23 to the user terminal 60. The user terminal 60 may provide a screen representing the diagnostic results through an application 61. The user may check the screen displayed on the user terminal 60, and when there is a connector with an abnormality among the battery connector 21, the system connector 22, and the vehicle connector 23, the user may take actions such as abnormality diagnosis and repair.

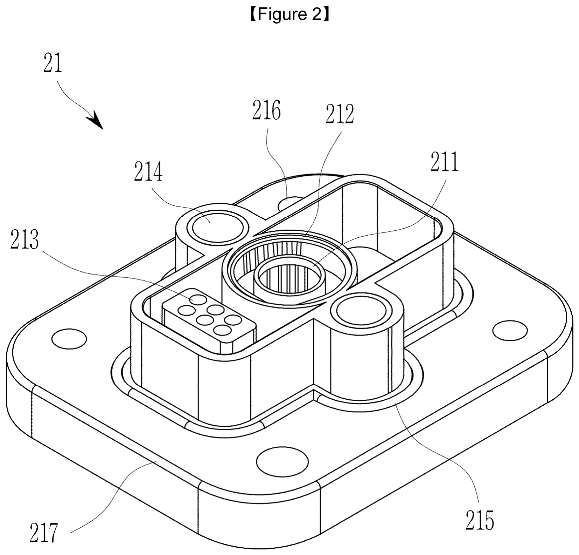

FIG. 2 is an exemplary diagram illustrating a detailed configuration of a battery connector.

Referring to FIG. 2, the battery connector 21 may include a positive pin 211, a negative pin 212, a terminal 213 for signal, a guide pin 214, a strap 215, a fixing hole 216, and a body 217. The battery connector 21 may be a female connector.

Referring to FIG. 2, the positive pin 211 may be connected to a positive pole of the battery pack 10. The negative pin 212 may be connected to a negative pole of the battery pack 10. The positive pin 211 and the negative pin 212 may be connected to a path through which a large current of the battery pack 10 flows.

Referring to FIG. 2, the terminal 213 for signal may transmit and receive a signal to the system connector 22 when the battery connector 21 is connected to and from the system connector 22. The terminal 213 for signal may transmit and receive a signal to and from the vehicle connector 23 when the battery pack 10 is connected to the vehicle connector 23. The guide pin 214 may be an area that is coupled to a guide pin of the system connector 22 or the vehicle connector 23. The strap 215 may be provided with a rubber material for waterproofing the positive pin 211, the negative pin 212, the terminal 213 for signal, etc. The fixing hole 216 is a plurality of holes provided in the body 217, and a fixing member for fixing the battery connector 21 and the system connector 22, or for fixing the battery connector 21 and the vehicle connector 23 may be coupled to the fixing hole 216.

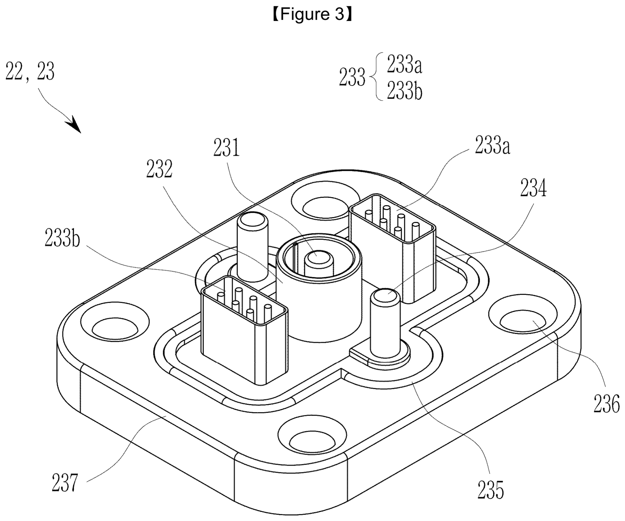

FIG. 3 is an exemplary diagram illustrating a detailed configuration of a system connector or a vehicle connector.

Referring to FIG. 3, the system connector 22 and the vehicle connector 23 may include a positive pin 231, a negative pin 232, a terminal 233 for signal, a guide pin 234, a strap 235, a fixing hole 236, and a body 237. Each of the system connector 22 and the vehicle connector 23 may be a male connector.

Referring to FIGS. 2 and 3, when the system connector 22 or the vehicle connector 23 is connected to the battery connector 21, the positive pin 231 illustrated in FIG. 3 may be electrically connected by contacting the positive pin 211 illustrated in FIG. 2, and the negative pin 232 illustrated in FIG. 3 may be electrically connected by contacting the negative pin 212 illustrated in FIG. 2. The positive pin 231 may be connected to a positive terminal of the BSS 30 or a positive terminal of the vehicle 40. The negative pin 232 may be connected to a negative terminal of the BSS 30 or a negative terminal of the vehicle 40. The positive pin 231 and the negative pin 232 may be connected to a path through which a large current of the BSS 30 or the vehicle 40 flows.

Referring to FIGS. 2 and 3, when the system connector 22 or the vehicle connector 23 is connected to the battery connector 21, the terminal 233 for signal may be connected to the terminal 213 for signal illustrated in FIG. 2 to transmit and receive a signal to and from the battery connector 21. Referring to FIG. 3, the terminal 233 for signal may include two terminals 233a and 233b. The two terminals 233a and 233b may be configured to be symmetrical to each other with respect to the positive pin 231, and the two terminals 233a and 233b may be connected to each other. Accordingly, the terminal 213 for signal illustrated in FIG. 2 may transmit and receive a signal to and from the BSS 30 or the vehicle 40 regardless of whether the terminal 213 for signal is connected to either terminal 233a, or 233b. This is to enable the signal to be transmitted and received regardless of a coupling direction when the battery connector 21 is coupled to the system connector 22 or the vehicle connector 23.

Referring to FIGS. 2 and 3, the guide pin 234 may be an area that is coupled to the guide pin 214 of the battery connector 21. The strap 235 may be provided with a rubber material for waterproofing the positive pin 231, the negative pin 232, the terminal 233 for signal, etc. The fixing hole 236 is a plurality of holes provided in the body 237, and a fixing member for fixing the system connector 22 and the battery connector 21, or fixing the system connector 22 and the battery connector 21 may be coupled to the fixing hole 236.

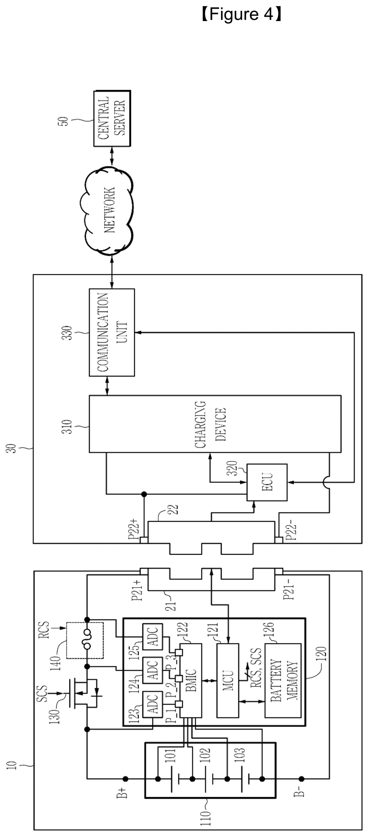

FIG. 4 is a block diagram schematically illustrating a configuration of the battery pack and the BSS illustrated in FIG. 1.

Referring to FIG. 4, the contact resistance abnormality diagnosis system 1 may include the battery pack 10, the BSS 30, and the central server 50. Hereinafter, in the description of battery pack 10, BSS 30, and central server 50, any part of the description that overlaps with the previous description may be omitted.

Referring to FIG. 4, the battery pack 10 may include a battery module 110, a battery management system (BMS) 120, a switching element 130, a relay 140, and the battery connector 21. Both ends P21+ and P21- of the battery pack 10 may be electrically connected to the battery connector 21.

The battery module 110 may include a plurality of battery cells 101 to 103. In FIG. 4, the plurality of battery cells 101 to 103 are connected in series, and the number of battery cells 101 to 103 is illustrated as three, but this is for convenience of description and the present disclosure is not limited thereto. The battery module 110 may be implemented as two or more battery cells connected in series, a plurality of battery cells having two or more battery cells connected in parallel, or two or more battery cells connected in parallel.

A positive node B+ of the battery module 110 may be connected to the positive electrode of the battery cell 101 located on the most positive side among the plurality of battery cells 101 to 103. A negative node B- of the battery module 110 may be connected to the negative electrode of the battery cell 103 located on the most negative side among the plurality of battery cells 101 to 103.

One end of the switching element 130 may be connected to the positive node B+ of the battery module 110, and the other end of the switching element 130 may be connected to one end of the relay 140. The other end of the relay 140 may be connected to one end P21+ of the battery module 110. The switching element 130 may connect a power supply of the battery pack 10 to the BSS 30 or the vehicle 40. For example, the switching element 130 may be a power distribution unit (PDU) such as a relay or a contactor in an electric vehicle (EV).

The BMS 120 may include a main control unit (MCU) 121, a battery monitoring integrated circuit (BMIC) 122, a plurality of analog-to-digital converters (ADCs) 123 to 125, and a battery memory 126.

The battery memory 126 may include a storage medium of at least type of a flash memory type, a hard disk type, a multimedia card micro type, a memory of card type (for example, an SD or XD memory, etc.), a random access memory (RAM), a static random access memory (SRAM), a read-only memory (ROM), an electrically erasable programmable read-only memory (EEPROM), a programmable read-only memory (PROM), a magnetic memory, a magnetic disk, and an optical disk.

The MCU 121 may control an operation of the BMIC 122. The MCU 121 may generate a relay control signal RCS and a switching control signal SCS and supply these generated relay control signal RCS and switching control signal SCS to the corresponding elements among the relay 140 and the switching element 130.

The switching element 130 and the relay 140 may be implemented as a fuse, a field effect transistor (FET), a relay, a contactor, etc. One end of the switching element 130 is connected to one end B+ of the battery module 110, and the other end of the switching element 130 is connected to one end of the relay 140. The closing and opening of the switching element 130 may be controlled according to the switching control signal SCS supplied from the MCU 121.

One end of the relay 140 is connected to the other end of the switching element 130, and the other end of the relay 140 is connected to one end P21+ of the battery pack 10. The closing and opening of the relay 140 may be controlled according to the relay control signal RCS supplied from the MCU 121.

The battery pack 10 may be connected to an external device. The external device may include a load and a charging device such as an inverter, a converter, etc. In an exemplary embodiment, the external device may be provided in the BSS 30 or the vehicle 40.

The BMIC 122 may be connected to both ends of each of the plurality of battery cells 101 to 103. The BMIC 122 may derive cell voltages of each of the plurality of battery cells 101 to 103 based on the signals received from both ends of each of the plurality of battery cells 101 to 103. The BMIC 122 may transmit the cell voltages of each of the plurality of battery cells 101 to 103 to MCU 121.

The BMIC 122 may include a plurality of terminals P_1 to P_3. The BMIC 122 may be connected to the plurality of ADCs 123 to 125 through the plurality of terminals P_1 to P_3. The BMIC 122 may receive voltage signals from one end of the switching element 130, the other end of the switching element 130, and the other end of the relay 140 based on the signals received through the plurality of terminals P_1 to P_3. The BMIC 122 may derive voltages across the switching element 130 and voltages across the relay 140 based on signals received from the plurality of terminals P_1 to P_3. The BMIC 122 may determine whether the switching element 130, the relay 140, etc., are abnormal in a control situation based on the voltages across the switching element 130 and voltages across the relay 140. Here, the control situation may include the MCU 121 that controls the switching element 130 to open/close, and/or the relay 140 to open/close.

The BMIC 122 may derive the voltage of one end P21+ of the battery pack 10 based on the signal received from one end P_3.

The BMIC 122 may transmit the voltage of one end of switching element 130, the voltage of the other end of the switching element 130, and transmit the voltage of one end P21+ of the battery pack 10 to the MCU 121. Hereinafter, for convenience of description, the voltage of one end P21+ of battery pack 10 is referred to as "pack positive voltage."

The BSS 30 may include a charging device 310, an electronic control unit (ECU) 320, a communication unit 330, and the system connector 22. Both ends P22+ and P22- of the BSS 30 may be electrically connected to the system connector 22. The system connector 22 may be connected to at least one component in the BSS 30. Both ends P22+ and P22- of the BSS 30 may be electrically connected to the MCU 410.

The charging device 310 may supply power to the battery pack connected to both ends P22+ and P22- of the BSS 30. Both ends of the charging device 310 may be connected to the system connector 22. One end of the charging device 310 may be connected to one end P22+ of the BSS 30, and the other end of the charging device 310 may be connected to the other end P22- of the BSS 30. The charging device 310 may transmit and receive a signal to and from the ECU 320. The MCU 410 may communicate with the central server 50 through the network and transmit and receive a signal and/or data.

The ECU 320 may control the operations of the charging device 310 and the communication unit 330. The ECU 320 may derive the voltage of one end P22+ of the BSS 30 based on the signal received from one end P22+ of the BSS 30.

The communication unit 330 may communicate with the central server 40 through the network based on the signal received from the ECU 320. The communication unit 330 may include a configuration that communicates with other configurations in a wired and/or wireless manner.

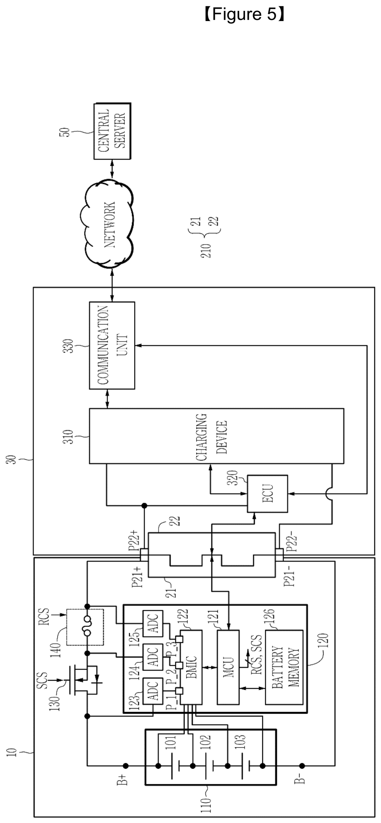

The battery connector 21 may be coupled to the system connector 22. Hereinafter, an appearance in which the battery connector 21 is coupled to the system connector 22 will be described with reference to FIG. 5.

FIG. 5 is a block diagram schematically illustrating an appearance in which the battery pack according to an exemplary embodiment is coupled to the BSS illustrated in FIG. 4.

Referring to FIG. 5, the contact resistance abnormality diagnosis system 1 may include the battery pack 10, the BSS 30, and the central server 50. Hereinafter, in the description of the battery pack 10, the BSS 30, and the central server 50, any part of the description that overlaps with the previous description may be omitted.

When the battery connector 21 is coupled to the system connector 22, the battery connector 21 and the system connector 22 are electrically connected, one end P21+ of the battery pack 10 may be electrically connected to one end P22+ of the BSS 30, and the other end P21- of the battery pack 10 may be electrically connected to the other end P22- of the BSS 30.

Hereinafter, the battery connector 21 and the system connector 22 in the coupled state are referred to as a connector assembly 210. When the battery connector 21 is connected to the system connector 22, the MCU 121 may transmit and receive a signal to and from the ECU 320 through the connector assembly 210.

The BSS 30 may include the charging device. Both ends P21+ and P21- of the battery pack 10 may be connected to the charging device of the BSS 30 and may be charged by receiving power from the charging device.

Hereinafter, the MCU 121 transmitting and receiving the signal and/or data to and from the ECU 320 may indicate that the MCU 121 transmit and receive the signal and/or data to and from the ECU 320 through the connector assembly 210.

The ECU 320 may transmit the signal representing the voltage (hereinafter, "BSS positive voltage") of one end P22+ of the BSS 30 to the MCU 121.

The MCU 121 may calculate the contact resistance of the connector assembly 210 based on the pack positive voltage and the BSS positive voltage. The MCU 121 may calculate the contact resistance value of the connector assembly 210 as in [Equation 1] below.

[Equation 1]

$$\text{Connector contact resistance} = abs\left(\frac{VP - VP'}{I}\right)$$

Here, VP may indicate the pack positive voltage (unit: V), VP' may indicate the BSS positive voltage (unit: V), and I may indicate the charging current (unit: A) of the battery pack 10. Referring to [Equation 1], the contact resistance (unit: $\Omega$) of the connector assembly 210 may be a value obtained by dividing the difference between the pack positive voltage and the BSS positive voltage by the charging current of the battery pack 10. Here, the charging current of the battery pack 10 may be a value received from the ECU 320 or a value pre-stored in the BMS 120.

Based on [Equation 1], the MCU 121 may calculate a plurality of first contact resistance values corresponding to a plurality of first time points when the battery connector 21 and the system connector 22 are coupled to the connector assembly 210.

The MCU 121 may store the calculated contact resistance values of the connector assembly 210 in the battery memory 126. The MCU 121 may transmit the calculated contact resistance value of the connector assembly 210 to the BSS 30.

The communication unit 330 may transmit the charging contact resistance information including the contact resistance value of the connector assembly 210 received from the MCU 121 to the central server 50. The charging contact resistance information may include the contact resistance value of the connector assembly 210, the identification value of the battery 10 that transmits the contact resistance value of the connector assembly 210, the identification value of the BSS 30, the mounting time point of the connector assembly 210, etc.

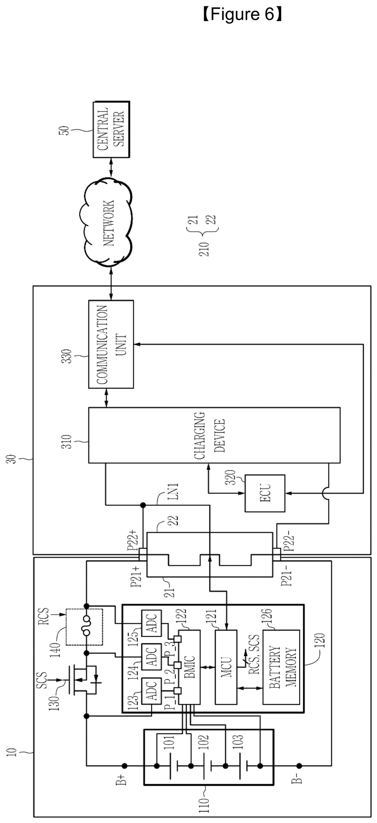

FIG. 6 is a block diagram illustrating an exemplary embodiment in which one end of the BSS illustrated in FIG. 5 is connected to a system connector.

Hereinafter, in the description of the battery pack 10, the BSS 30, and the central server 50, any part of the description that overlaps with the previous description may be omitted.

Referring to FIG. 6, in some exemplary embodiments, one end P22+ of the BSS 30 may be electrically connected to the system connector 22 via a wiring LN1. The MCU 121 may receive a signal representing one end P22+ voltage of the BSS 30 via the connector assembly 210. The MCU 121 may derive the BSS positive voltage based on the signal representing the voltage of one end P22+ of the BSS 30.

The method by which the BMS 120 illustrated in FIGS. 5 and 6 receives a signal representing the voltage of one end P22+ of the BSS 30 from the BSS 30 is an example, and the present disclosure is not limited thereto. The BMS 120 may receive a signal representing the voltage of one end P22+ of the BSS 30 from the BSS 30 by various methods.

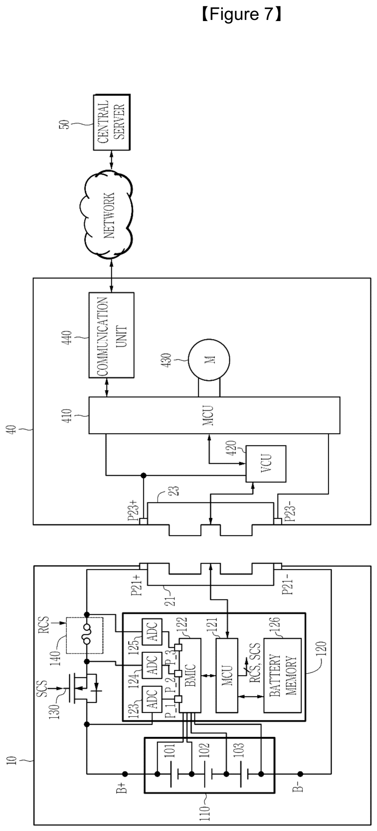

FIG. 7 is a block diagram schematically illustrating the configuration of the battery pack and the vehicle illustrated in FIG. 1.

Referring to FIG. 7, the contact resistance abnormality diagnosis system 1 may include the battery pack 10 and the vehicle 40. Hereinafter, descriptions of parts of the description of the battery pack 10 and the vehicle 40 that overlap with the previous description may be omitted.

The vehicle 40 may include an MCU 410, a vehicle control unit (VCU) 420, a motor 430, a communication unit 440, and the vehicle connector 23. Both ends P23+ and P23- of the vehicle 40 may be electrically connected to the vehicle connector 23. The vehicle connector 23 may be connected to at least one component in the vehicle 40.

The MCU 410 may control the operation of the VCU 420, the motor 430, and the communication unit 440. The MCU 410 may transmit and receive a signal to and from the VCU 420. The MCU 410 may control the operation of the motor 430. The VCU 420 may derive the voltage of one end P23+ of the vehicle 40 based on the signal received from one end P23+ of the vehicle 40.

The communication unit 440 may communicate with the central server 50 through the network based on the signal received from the ECU 410. The communication unit 440 may include a configuration that communicates with other configurations in a wired and/or wireless manner.

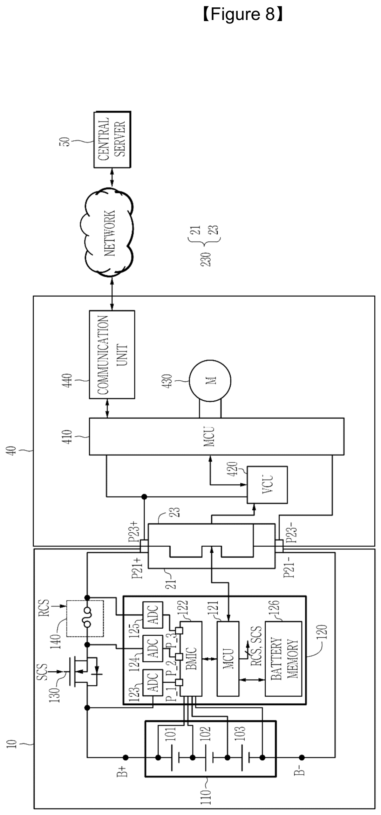

The battery connector 21 may be coupled to the vehicle connector 23. Hereinafter, an image of the battery connector 21 coupled to the vehicle connector 23 will be described with reference to FIG. 8.

FIG. 8 is a block diagram schematically illustrating an appearance in which the battery pack according to an exemplary embodiment is connected to the vehicle illustrated in FIG. 7.

Referring to FIG. 8, the contact resistance abnormality diagnosis system 1 may include the battery pack 10 and the vehicle 40. Hereinafter, descriptions of parts of the description of the battery pack 10 and the vehicle 40 that overlap with the previous description may be omitted.

When the battery connector 21 is connected to the vehicle connector 23, the battery connector 21 and the vehicle connector 23 are electrically connected, one end P21+ of the battery pack 10 is electrically connected to one end P23+ of the vehicle connector 23, and the other end P21- of the battery pack 10 may be electrically connected to the other end P23- of the vehicle connector 23.

Hereinafter, the battery connector 21 and the vehicle connector 23 in the state where the battery connector 21 and the vehicle connector 23 are connected are referred to as a connector assembly 230. When the battery connector 21 is connected to the vehicle connector 23, the MCU 121 may transmit and receive a signal to and from the VCU 420 through the connector assembly 230.

The vehicle 40 may include a load. Both ends P21+ and P21- of the battery pack 10 are connected to the load of the vehicle 40, so that the power supplied by the battery pack 10 may be discharged through the load.

Hereinafter, the MCU 121 transmitting and receiving the signal and/or data to and from the VCU 420 may indicate that the MCU 121 transmits and receives the signal and/or data to and from the VCU 420 via the connector assembly 230.

The VCU 420 may transmit a signal representing the voltage of one end P23+ of the vehicle 40 (hereinafter, "vehicle positive voltage") to the MCU 121.

The MCU 121 may calculate the contact resistance of the connector assembly 230 based on the pack positive voltage and the vehicle positive voltage. The MCU 121 may calculate the contact resistance value of the connector assembly 230 as in [Equation 2] below.

[Equation 2]

$$Connector\ contact\ resistance = abs\left(\frac{VP - VP''}{I}\right)$$

Here, VP may indicate the battery pack positive voltage (unit: V), VP" may indicate the vehicle positive voltage (unit: V), and I' may indicate the discharging current (unit: A) of the battery pack 10. Referring to [Equation 2], the contact resistance (unit: Ω) of the connector assembly 230 may be a value obtained by dividing the difference between the pack positive voltage and the vehicle positive voltage by the discharging current of the battery pack 10. Here, the discharging current of the battery pack 10 may be a value received from the ECU 320 or a value pre-stored in the BMS 120.

Based on [Equation 2], the MCU 121 may calculate a plurality of second contact resistance values corresponding to a plurality of second time points when the battery connector 21 and the vehicle connector 23 are coupled to the connector assembly 230.

The MCU 121 may store the calculated contact resistance values of the connector assembly 210 in the battery memory 126. The MCU 121 may transmit the calculated contact resistance value of the connector assembly 230 to the vehicle 40.

The communication unit 440 may transmit the discharging contact resistance information including the contact resistance value of the connector assembly 230 received from the MCU 121 to the central server 50. The discharging contact resistance information may include the contact resistance value of the connector assembly 230, the identification value of the battery 10 that transmits the contact resistance value of the connector assembly 230, the identification value of the vehicle 40, the mounting time point of the connector assembly 230, etc. The vehicle 40 may be coupled to the battery pack 10 multiple times. The vehicle 40 may transmit the discharging contact resistance information to the central server 50 at any time point during a predetermined time period from the mounting time point for each of the multiple couplings of the connector assembly 230.

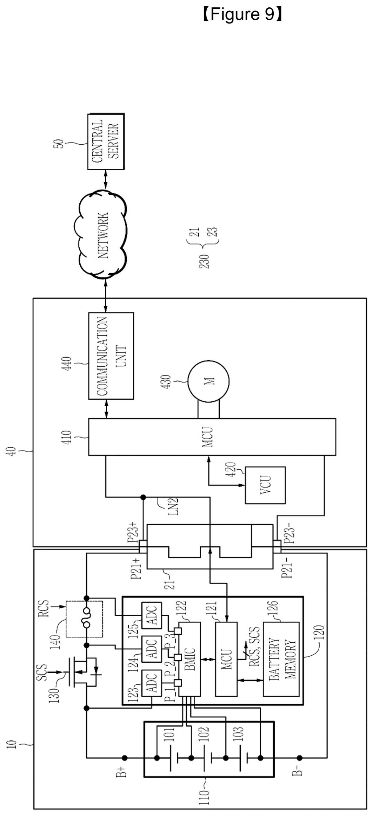

FIG. 9 is a block diagram schematically illustrating an exemplary embodiment in which one end of the vehicle illustrated in FIG. 8 is connected to the vehicle connector.

Hereinafter, in the description of the battery pack 10, the vehicle 40, and the central server 50, any part of the description that overlaps with the previous description may be omitted.

Referring to FIG. 9, in some exemplary embodiments, one end P23+ of the vehicle 40 may be electrically connected to the vehicle connector 23 through a wiring LN2. The MCU 121 may receive a signal representing one end P22+ voltage of the BSS 30 via the connector assembly 230. The MCU 121 may derive the BSS positive voltage based on the signal representing the voltage of one end P22+ of the BSS 30.

The method by which the BMS 120 illustrated in FIGS. 8 and 9 receives a signal representing the voltage of one end P23+ of the vehicle 40 from the vehicle 30 is an example, and the present disclosure is not limited thereto. The BMS 120 may receive a signal representing the voltage of one end P23+ of the vehicle 40 from the vehicle 30 by various methods.

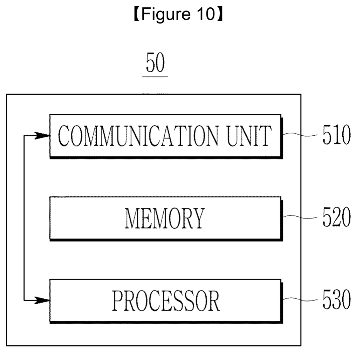

FIG. 10 is a block diagram schematically illustrating a detailed configuration of a central server illustrated in FIG. 1 and FIGS. 4 to 9.

Referring to FIG. 10, the central server 50 may include a communication unit 510, a memory 520, and a processor 530.

The communication unit 510 may communicate with the BSS (30 in FIG. 1 and FIGS. 4 to 6) and/or a vehicle (40 in FIG. 1 and FIGS. 7 to 9) through a network to transmit and receive signals and/or data. The BSS (30 in FIG. 1 and FIGS. 4 to 6) may be coupled to the battery pack 10 multiple times. The vehicle (40 in FIG. 1 and FIGS. 7 to 9) may be coupled to the battery pack 10 multiple times. The communication unit 510 may receive a plurality of pieces of charging contact resistance information corresponding to each of the plurality of connector assemblies 210 from the BSS (30 in FIG. 1 and FIGS. 4 to 6). The communication unit 510 may receive a plurality of pieces of discharging contact resistance information corresponding to each of the plurality of connector assemblies 230 from the vehicle (40 in FIG. 1 and FIGS. 7 to 9).

The memory 520 may store a program (hereinafter, "connector contact abnormality diagnosis program") for diagnosing a connector contact abnormality for a swappable battery pack through the contact resistance of the connector. The memory 520 may store the plurality of pieces of charging contact resistance information and the plurality of pieces of discharging contact resistance information. The memory 520 may include a storage medium of at least type of a flash memory type, a hard disk type, a multimedia card micro type, a memory of card type (for example, an SD or XD memory, etc.), a random access memory (RAM), a static random access memory (SRAM), a read-only memory (ROM), an electrically erasable programmable read-only memory (EEPROM), a programmable read-only memory (PROM), a magnetic memory, a magnetic disk, and an optical disk.

The processor 530 may execute the connector contact abnormality diagnosis program to diagnose a contact abnormality of the connector assembly 210 or the connector assembly 230 based on the charging contact resistance information and the discharging contact resistance information received from the BSS 30 and/or the vehicle 40. In addition, the processor 530 may determine which of the battery connector 21 and the system connector 22 constituting the connector assembly 210 is in a abnormal state, and which of the battery connector 21 and the vehicle connector 23 constituting the connector assembly 230 is in a faulty state.

The "processor" means a configuration that processes an operation, a logic operation, a determination operation, etc., to provide at least one function, and this may be implemented by hardware, software, or a combination of hardware and software. For example, the processor 530 may be implemented by software such as a task, a class, a subroutine, a process, an object, an execution thread, a program performed in a predetermined area on a memory, or hardware such as a field-programmable gate array (FPGA) or an application-specific integrated circuit (ASIC), and may also be formed by a combination of the software and hardware. The processor may be included in a computer readable storage medium or may be partially dispersed and distributed in a plurality of computers.

The processor 530 may extract the mounting time point of the connector assembly 210 from each of the plurality of charging contact resistance information, and may extract the mounting time point of the connector assembly 230 from each of the plurality of discharging contact resistance information. The processor 530 may arrange the mounting time point (hereinafter, "charge mounting time point") of the plurality of connector assembly 210 and the extracted mounting time point (hereinafter, "discharge mounting time point") of the plurality of connector assembly 230 in an order of time. The processor 530 may generate the log table including the contact resistance value of the connector assembly 210 and the contact resistance value of the connector assembly 230. The log table may include the plurality of contact resistance values and the identification information corresponding to each of the plurality of contact resistance values. Hereinafter, the identification information may include the identification value of the battery 10, the identification value of the BSS 30, the identification value of the vehicle 40, etc.

The plurality of charging contact resistance information received by the communication unit 510 includes information on battery packs to which each of the plurality of BSSs 30_1 to 30_3 is coupled, and thus may include contact resistance values calculated from battery packs other than the battery pack 10. Similarly, the plurality of discharging contact resistance information received by the communication unit 510 includes information on battery packs to which each of the plurality of vehicles 40_1 and 40_2 is combined, and thus may include contact resistance values calculated from battery packs other than the battery pack 10.

The processor 530 may distinguish the plurality of pieces of charging contact resistance information and the plurality of pieces of discharging contact resistance information according to the identification values of the plurality of battery packs to generate log tables for each battery pack. The processor 530 may perform the operation described below for each log table generated for each battery pack by distinguishing the plurality of pieces of charging contact resistance information and the plurality of pieces of discharging contact resistance information. For convenience of description below, the "log table" may represent the log table for the battery pack 10.

The processor 530 stores the log table in the memory 520, and the processor 530 may update the charging or discharging contact resistance information received in real time in the log table and store the updated charging or discharging contact resistance information in the memory 520.

The log table may be a table sorted according to the mounting order of the corresponding connector assembly 210 or 230 among the contact resistance values of the connector assembly 210 and the contact resistance values of the connector assembly 230. Since the battery pack 10 alternately repeats charging and discharging, the log table may sequentially display the discharging mounting time point and the charging mounting time point for one battery pack 10 one by one.

For example, the following description assumes that battery pack 10 is coupled to a first BSS (30_3 in FIG. 1) at a first time point, coupled to a first vehicle (40_1 in FIG. 1) at a second time point after the first time point, and coupled to a second BSS (30_1 in FIG. 1) at a third time point after the second time point. In this case, the log table may include contact resistance values listed in the following order: a contact resistance value of the connector assembly 210 between battery pack 10 and the first BSS (30_3 in FIG. 1), a contact resistance value of the connector assembly 230 between the battery pack 10 and the first vehicle (40_1 in FIG. 1), and a contact resistance value of the connector assembly 210 between the second BSSs (30_1 in FIG. 1).

Among the contact resistance values for multiple times included in the log table, the contact resistance value of the connector assembly 210 may include a contact resistance component of the battery connector 21 and a contact resistance component of the system connector 22. Among the contact resistance values for multiple times included in the log table, the contact resistance value of the connector assembly 230 may include the contact resistance component of the battery connector 21 and a contact resistance component of the vehicle connector 23. Considering the contact resistance components included in each contact resistance value and the fact that the time points corresponding to the contact resistance value of the connector assembly 210 and the time points corresponding to the contact resistance value of the connector assembly 230 appear alternately, the processor 530 may determine the states of the battery connector 21, the system connector 22, and the vehicle connector 23 based on the generated log table.

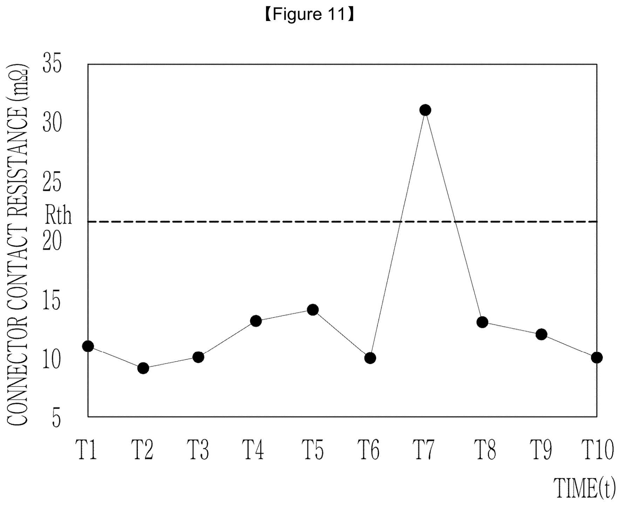

FIGS. 11, 12, and 13 are examples of graphs represented by log tables according to an exemplary embodiment.

Referring to FIGS. 1 and 11 to 13, T1 to T10 may represent the time points at which battery pack 10 is coupled to each of the plurality of BSSs 30_1 to 30_3 and each of the plurality of vehicles 40_1 and 40_2.

It is assumed that T1 is the time point when battery pack 10 is coupled to BSS 30_1, T3 is the time point when battery pack 10 is coupled to BSS 30_2, T5 is the time point when battery pack 10 is coupled to BSS 30_3, T7 is the time point when battery pack 10 is coupled to BSS 30_1, and T9 is the time point when battery pack 10 is coupled to BSS 30_1. Also, it is described under the assumption that T2 is the time point when battery pack 10 is coupled to the vehicle 40_1, T4 is the time point when battery pack 10 is coupled to the vehicle 40_2, T6 is the time point when battery pack 10 is coupled to the vehicle 40_2, T8 is the time point when battery pack 10 is coupled to the vehicle 40_1, and T10 is the time point when battery pack 10 is coupled to the vehicle 40_2.

The log table may include the plurality of contact resistance values for the connector assembly corresponding to the time points T1 to T10.

The processor 530 may determine the states of the battery connector 21, the system connector 22, and the vehicle connector 23 based on whether there is a contact resistance value exceeding a predetermined upper threshold value Rth among the plurality of contact resistance values included in the log table, the number of contact resistance values continuously exceeding the predetermined upper threshold value Rth, a slope of continuous contact resistance values, a trend line of the continuous contact resistance values, etc. For example, the processor 530 may determine the state based on the predetermined number of latest contact resistance values among the plurality of contact resistance values.

In an exemplary embodiment, the processor 530 may determine the states of the battery connector 21, the system connector 22, and the vehicle connector 23 based on whether a second resistance value immediately after a first resistance value exceeding the predetermined upper threshold value Rth among the plurality of contact resistance values included in the log table is less than the first resistance value.

When the first resistance value exceeding the upper threshold value Rth among the plurality of contact resistance values included in the log table and the second resistance value immediately after the first resistance value are smaller than the first resistance value, the processor 530 may determine, based on the identification information corresponding to the first resistance value, whether the first resistance value is a contact resistance corresponding to one of the plurality of BSSs 30_1 to 30_3 and the plurality of vehicles 40_1 and 40_2. The processor 530 may determine, among the plurality of BSSs 30_1 to 30_3 and the plurality of vehicles 40_1 and 40_2, the state of the BSS or the state of the vehicle corresponding to the contact resistance value exceeding the upper threshold value Rth among the plurality of contact resistance values included in the log table as the abnormal state.

In the example in FIG. 11, at time point T7, there is the contact resistance value exceeding the upper threshold value Rth among the plurality of contact resistance values included in the log table. The processor 530 determines that the state of the BSS 30_1 is abnormal because the first resistance value at time point T7 exceeds the upper limit threshold value Rth, the second resistance value at time point T8 immediately after the first resistance value is smaller than the first resistance value, and time point T7 is the time point when the battery pack 10 is coupled to the BSS 30_1.

In some exemplary embodiments, the processor 530 may determine the states of the battery connector 21, the system connector 22, and the vehicle connector 23 based on whether the number of contact resistance values that continuously exceed the upper limit threshold value Rth among the plurality of contact resistance values included in the log table is the predetermined number or more. Here, the predetermined number may be two or more.

When there are the predetermined number (for example, 3) or more contact resistance values that continuously exceed the upper limit threshold value Rth among the plurality of contact resistance values included in the log table, the processor 530 may determine the state of the battery connector 21 as the abnormal state.

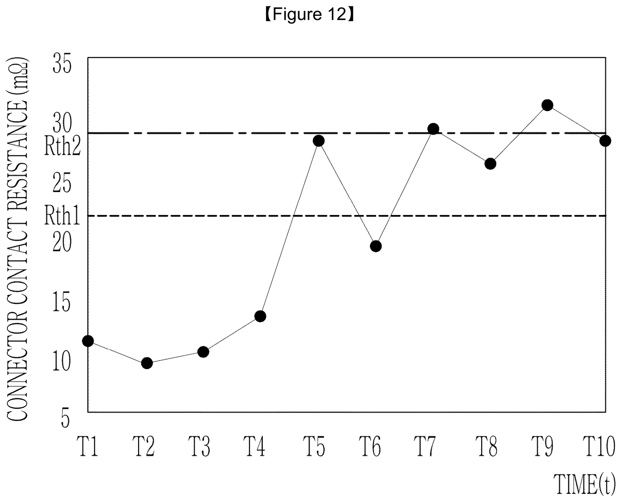

In the example in FIG. 12, at time points T9 and T10, there are 3 or more contact resistance values that continuously exceed a first upper limit threshold value Rth1 among the plurality of contact resistance values included in the log table. Since there are 3 or more contact resistance values that continuously exceed the first upper limit threshold value Rth1 at time points T9 and T10, the processor 530 may determine the state of the battery connector 21 as an abnormal state at time point T9 or T10.

In addition, among the plurality of contact resistance values, the predetermined number or more of contact resistance values that continuously exceed the first upper limit threshold value Rth1 and the predetermined number or more of contact resistance values that exceed the first upper limit threshold value Rth1 (hereinafter, "target contact resistance values") may be obtained as representative values of the contact resistance values for each of the plurality of BSSs 30_1 to 30_3 and the plurality of vehicles 40_1 and 40_2. Here, the representative value may be at least one of an average value, a median value, a maximum value, a minimum value, a slope, etc., for example. When the representative value of the contact resistance values among the plurality of BSSs 30_1 to 30_3 and the plurality of vehicles 40_1 and 40_2 exceeds a predetermined second upper limit threshold value Rth2, the processor 530 may determine the state of the BSS corresponding to the representative value or the state of the corresponding vehicle as the abnormal state.

In the example in FIG. 12, since there are three or more contact resistance values that continuously exceed the first upper limit threshold value Rth1 at time points T9 and T10, and since among the contact resistance values (contact resistance values corresponding to each of T7 to T10) that continuously exceed the first upper limit threshold value Rth1, an average value (approximately 30 m$\Omega$) of the contact resistance values corresponding to T7 and T9 coupled to BSS 30_1 exceeds the second upper limit threshold value Rth2, the processor 530 may also determine the state of the BSS 30_1 as the abnormal state.

In some exemplary embodiments, the processor 530 may determine the states of the battery connector 21, the system connector 22, and the vehicle connector 23 based on whether the slope between two contact resistance values at two adjacent time points among the plurality of contact resistance values included in the log table is continuously greater than a predetermined critical slope.

When the slopes of two contact resistance values at adjacent time points among the plurality of contact resistance values included in the log table are continuously greater than or equal to a predetermined critical slope, the processor 530 may determine the state of the battery connector 21 as the abnormal state.

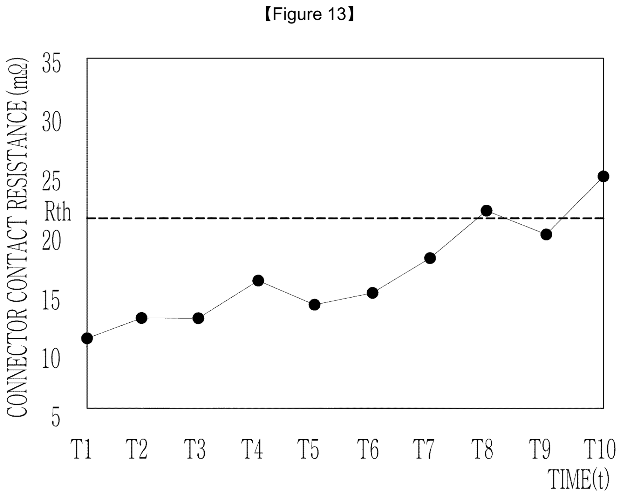

In the example in FIG. 13, it is assumed that a first slope of the contact resistance value corresponding to a time point T5 and the contact resistance value corresponding to a time point T6 is greater than or equal to the critical slope, a second slope of the contact resistance value corresponding to a time point T6 and the contact resistance value corresponding to a time point T7 is greater than or equal to the critical slope, and the third slope of the contact resistance value corresponding to a time point T7 and the contact resistance value corresponding to a time point T8 are greater than or equal to the critical slope. At the time point T8, the processor 530 may determine the state of the battery connector 21 as the abnormal state because the slopes of the two contact resistance values at adjacent time points are three or more consecutive values greater than or equal to the predetermined critical slope.

The description referring to FIGS. 11 to 13 described above is an example of the operation of the processor 530 determining the states of the battery connector 21, the system connector 22, and the vehicle connector 23, and the present disclosure is not limited thereto. The processor 530 may identify a connector to be determined as an abnormal state among the battery connector 21, the system connector 22, and the vehicle connector 23 based on the plurality of contact resistance values included in the log table.

The processor 530 may strengthen the diagnosis of the battery connector 21, the system connector 22, and the vehicle connector 23 by using machine learning

By using, as training data, data that the user determines that an actual abnormality has occurred for the connector determined to be in an abnormal state among the states of each of the battery connector 21, the system connector 22, and the vehicle connector 23, the accuracy may be improved through feedback on the diagnosis and the diagnosis may be subdivided.

For example, when the processor 530 determines the state of the target system connector 30_1 among the plurality of system connectors 30_1 to 30_3 in FIG. 1 as the abnormal state and the communication unit 510 transmits the diagnosis result to the user terminal 60, the user may check the state of the target system connector 30_1 and input whether the actual abnormality has occurred to the user terminal 60. The user terminal 60 may transmit the data input by the user to the central server 50 through the application 61. The machine learning model may train the method of diagnosing the states of each of the battery connector 21, the system connector 22, and the vehicle connector 23 by using the log table that uses, the training data, the state of the target system connector 30_1 determined by the processor 530 and the data input by the user.

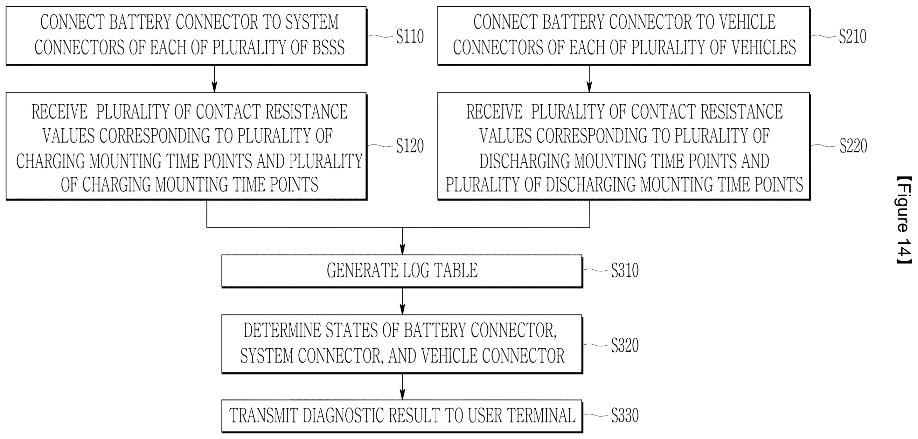

FIG. 14 is a flowchart of a contact resistance abnormality diagnosis method according to an exemplary embodiment.

Hereinafter, in the description of the battery pack 10, the BSS 30, and the central server 50, any part of the description that overlaps with the previous description may be omitted.

Referring to FIG. 14, the battery connector 21 may be coupled to the connector assembly (210 in FIGS. 5 and 6, hereinafter the same) at a plurality of charging mounting time point with a plurality of system connectors (22_1 to 22_3 in FIG. 1) (S110).

In step S110, when the battery connector 21 is coupled to the plurality of system connectors (22_1-22_3 in FIG. 1) by the connector assembly 210 at the plurality of charging mounting time point, the communication unit 510 may receive the plurality of first contact resistance values for the connector assembly 210 corresponding to the plurality of charging mounting time points and the plurality of charging mounting time points from the plurality of BSSs (30_1-30_3 in FIG. 1) (S120).

In addition, the battery connector 21 may be coupled to the plurality of vehicle connectors (23_1, 23_2 in FIG. 1) at the plurality of discharging mounting time points by the connector assembly (230 in FIG. 8 and FIG. 9, hereinafter the same) (S210).

In step S210, when the battery connector 21 is coupled to the plurality of vehicle connectors (23_1, 23_2 in FIG. 1) as the connector assembly at the plurality of discharging mounting time points, the communication unit 510 may receive the plurality of second contact resistance values for the connector assembly 230 corresponding to the plurality of discharging mounting time points and the plurality of discharging mounting time points from the plurality of vehicles (40_1, 40_2 in FIG. 1) (S220).

The processor 530 may generate the log table by arranging the plurality of first contact resistance values received in step S120 and the plurality of second contact resistance values received in step S220 in an order of time of the corresponding points among the plurality of discharging mounting time points and the plurality of charging mounting time points (S310).

The processor 530 stores the log table in the memory 520, and the processor 530 may update the received charging or discharging contact resistance information in the log table and store the updated charge or discharging contact resistance information in the memory 520.

The processor 530 may determine the states of the battery connector 21, the system connector 22, and the vehicle connector 23 based on the log table (S320).

The communication unit 510 may transmit the diagnosis results indicating the determined state of the battery connector 21, the system connector 22, and the vehicle connector 23 to the user terminal 60 (S330).

Although the embodiments of the present disclosure have been described in detail above, the scope of the present disclosure is not limited thereto, and various modifications and improvements by those of ordinary skill in the field to which the present disclosure pertains belong to the scope of the present disclosure.

**Claims**

1.  A contact resistance abnormality diagnosis method performed by allowing a processor to execute a connector contact abnormality diagnosis program stored in a memory, the contact resistance abnormality diagnosis method comprising:

    when a battery connector of a battery pack is coupled to a plurality of system connectors of a plurality of battery swapping systems (BSSs) by a first connector assembly at a plurality of first time points, receiving, by a central server, a plurality of first contact resistance values for the first connector assembly corresponding to the plurality of first time points from the plurality of BSSs;
    when the battery connector is connected to a plurality of vehicle connectors of a plurality of vehicles at a plurality of second time points by a second connector assembly, receiving, by the central server, a plurality of second contact resistance values for the second connector assembly corresponding to the plurality of second time points from the plurality of vehicles;
    arranging, by the central server, the plurality of first contact resistance values and the plurality of second contact resistance values in an order of time of the plurality of first time points and the plurality of second time points to generate a log table; and
    determining states of the battery connector, the plurality of system connectors, and the plurality of vehicle connectors based on the log table.

2.  The contact resistance abnormality diagnosis method of claim 1, further comprising:
    transmitting a diagnosis result indicating the states of the battery connector, the plurality of system connectors, and the plurality of vehicle connectors to a user terminal.

3.  The contact resistance abnormality diagnosis method of claim 1, wherein:

    each of the plurality of first contact resistance values
    is a value derived, by the battery pack, by dividing a difference between a positive terminal voltage of the battery connector and a positive terminal voltage of the corresponding system connector among the plurality of system connectors at each of the plurality of first time points by a charging current of the battery pack.

4.  The contact resistance abnormality diagnosis method of claim 1, wherein:

    each of the plurality of second contact resistance values
    is a value derived, by the battery pack, by dividing a difference between a positive terminal voltage of the battery connector and a positive terminal voltage of the corresponding vehicle connector among the plurality of vehicle connectors at each of the plurality of second time points by a discharging current of the battery pack.

5.  The contact resistance abnormality diagnosis method of claim 1, further comprising:

    when a second resistance value immediately after a first resistance value exceeding a predetermined upper threshold value among the plurality of first contact resistance values and the plurality of second contact resistance values is smaller than the first resistance value,
    determining a state of a system connector corresponding to the first resistance value or a vehicle connector corresponding to the first resistance value among the plurality of system connectors and the plurality of vehicle connectors as an abnormal state.

6. The contact resistance abnormality diagnosis method of claim 1, further comprising:

   when contact resistance values that continuously exceed a predetermined upper threshold value among the plurality of first contact resistance values and the plurality of second contact resistance values are a predetermined number or more,
   determining the state of the battery connector as an abnormal state.

7. The contact resistance abnormality diagnosis method of claim 1, further comprising:

   when a slope between two contact resistance values at two adjacent time points among the plurality of first contact resistance values and the plurality of second contact resistance values is continuously greater than or equal to a predetermined critical slope,
   determining the state of the battery connector as an abnormal state.

8. A contact resistance abnormality diagnosis system, comprising:

   a memory that stores a connector contact abnormality diagnosis program for a swappable battery pack;
   a processor that executes the connector contact abnormality diagnosis program to determine states of a battery connector of the battery pack, a plurality of system connectors of a plurality of battery swapping systems (BSSs), and a plurality of vehicle connectors of a plurality of vehicles; and
   when the battery connector is connected to the system connectors of each of the plurality of BSSs by a first connector assembly at a plurality of first time points, a communication unit that receives a plurality of first contact resistance values for the first connector assembly corresponding to the plurality of first time points from the plurality of BSSs, and when the battery connector is connected to the vehicle connectors of each of the plurality of vehicles by a second connector assembly at a plurality of second time points, receives a plurality of second contact resistance values for the second connector assembly corresponding to the plurality of second time points from the plurality of vehicles,
   wherein the processor
   arranges the plurality of first contact resistance values and the plurality of second contact resistance values in an order of time of the plurality of first times and and the plurality of second times to generate a log table, and determines the states of the battery connector, the plurality of system connectors, and the plurality of vehicle connectors based on the log table.

9. The contact resistance abnormality diagnosis system of claim 8, wherein:

   the communication unit
   transmits a diagnosis result indicating the states of the battery connector, the plurality of system connectors, and the plurality of vehicle connectors to a user terminal.

10. The contact resistance abnormality diagnosis system of claim 8, wherein:

    the battery pack
    derives a corresponding contact resistance value among the plurality of first contact resistance values by dividing a difference between a positive terminal voltage of the battery connector and a positive terminal voltage of the corresponding system connector among the plurality of system connectors by a charging current of the battery pack, at each of the plurality of first time points.

11. The contact resistance abnormality diagnosis system of claim 8, wherein:

    the battery pack
    derives a corresponding contact resistance value among the plurality of second contact resistance values by dividing a difference between a positive terminal voltage of the battery connector and a positive terminal voltage of the corresponding vehicle connector among the plurality of vehicle connectors by a discharging current of the battery pack, at each of the plurality of second time points.

**12.** The contact resistance abnormality diagnosis system of claim 8, wherein:

when a second resistance value immediately after a first resistance value exceeding a predetermined upper threshold value among the plurality of first contact resistance values and the plurality of second contact resistance values is smaller than the first resistance value,
the processor
determines a state of a system connector corresponding to the first resistance value or a vehicle connector corresponding to the first resistance value among the plurality of system connectors and the plurality of vehicle connectors as an abnormal state.

**13.** The contact resistance abnormality diagnosis system of claim 8, wherein:

when contact resistance values that continuously exceed a predetermined upper threshold value among the plurality of first contact resistance values and the plurality of second contact resistance values are a predetermined number or more,
the processor
determines the state of the battery connector as an abnormal state.

**14.** The contact resistance abnormality diagnosis system of claim 8, wherein:

when a slope between two contact resistance values at two adjacent time points among the plurality of first contact resistance values and the plurality of second contact resistance values is continuously greater than or equal to a predetermined critical slope,
the processor
determines the state of the battery connector as an abnormal state.

【Figure 1】

【Figure 2】

【Figure 3】

【Figure 4】

【Figure 5】

【Figure 6】

【Figure 7】

【Figure 8】

【Figure 9】

【Figure 10】

50

COMMUNICATION UNIT — 510

MEMORY — 520

PROCESSOR — 530

【Figure 11】

【Figure 12】

【Figure 13】

【Figure 14】

CONNECT BATTERY CONNECTOR TO SYSTEM CONNECTORS OF EACH OF PLURALITY OF BSSS — S110

RECEIVE PLURALITY OF CONTACT RESISTANCE VALUES CORRESPONDING TO PLURALITY OF CHARGING MOUNTING TIME POINTS AND PLURALITY OF CHARGING MOUNTING TIME POINTS — S120

CONNECT BATTERY CONNECTOR TO VEHICLE CONNECTORS OF EACH OF PLURALITY OF VEHICLES — S210

RECEIVE PLURALITY OF CONTACT RESISTANCE VALUES CORRESPONDING TO PLURALITY OF DISCHARGING MOUNTING TIME POINTS AND PLURALITY OF DISCHARGING MOUNTING TIME POINTS — S220

GENERATE LOG TABLE — S310

DETERMINE STATES OF BATTERY CONNECTOR, SYSTEM CONNECTOR, AND VEHICLE CONNECTOR — S320

TRANSMIT DIAGNOSTIC RESULT TO USER TERMINAL — S330

## INTERNATIONAL SEARCH REPORT

| | International application No. |
|---|---|
| | **PCT/KR2024/013131** |

| A. | CLASSIFICATION OF SUBJECT MATTER |
|---|---|

**G01R 31/66**(2020.01)i; **G01R 27/20**(2006.01)i; **G01R 19/10**(2006.01)i; **G01R 27/08**(2006.01)i; **B60L 3/00**(2006.01)i; **B60L 53/80**(2019.01)i

According to International Patent Classification (IPC) or to both national classification and IPC

| B. | FIELDS SEARCHED |
|---|---|

Minimum documentation searched (classification system followed by classification symbols)

G01R 31/66(2020.01); B60L 53/16(2019.01); B60L 53/62(2019.01); B60L 53/66(2019.01); G01R 19/165(2006.01); G01R 27/02(2006.01); G01R 31/02(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 커넥터(battery connector), 접촉 저항(contact resistance), 시스템 커넥터 (system connector), 차량 커넥터(vehicle connector), 로그 테이블(log table)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | KR 10-2554673 B1 (SAMSUNG SDI CO., LTD.) 13 July 2023 (2023-07-13)<br>See paragraphs [0017]-[0046]. | 1-14 |
| Y | JP 06-242157 A (HITACHI LTD.) 02 September 1994 (1994-09-02)<br>See paragraphs [0004]-[0015] and figure 2. | 1-14 |
| Y | KR 10-2571289 B1 (KOREA AUTOMOTIVE TECHNOLOGY INSTITUTE) 28 August 2023 (2023-08-28)<br>See paragraphs [0041]-[0042]. | 3,4,10,11 |
| A | KR 10-2004310 B1 (SK INNOVATION CO., LTD.) 30 July 2019 (2019-07-30)<br>See paragraphs [0020]-[0029]. | 1-14 |
| A | US 2019-0232813 A1 (TOYOTA JIDOSHA KABUSHIKI KAISHA) 01 August 2019 (2019-08-01)<br>See paragraphs [0051]-[0070]. | 1-14 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **05 December 2024** | **05 December 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/013131**

| Patent document cited in search report | | | Publication date (day/month/year) | Patent family member(s) | | | Publication date (day/month/year) |
|---|---|---|---|---|---|---|---|
| KR | 10-2554673 | B1 | 13 July 2023 | CN | 114362278 | A | 15 April 2022 |
| | | | | EP | 3985782 | A2 | 20 April 2022 |
| | | | | EP | 3985782 | A3 | 27 April 2022 |
| | | | | JP | 2022-064324 | A | 25 April 2022 |
| | | | | JP | 7301925 | B2 | 03 July 2023 |
| | | | | KR | 10-2022-0048858 | A | 20 April 2022 |
| JP | 06-242157 | A | 02 September 1994 | None | | | |
| KR | 10-2571289 | B1 | 28 August 2023 | KR | 10-2023-0016068 | A | 01 February 2023 |
| KR | 10-2004310 | B1 | 30 July 2019 | KR | 10-2014-0062534 | A | 26 May 2014 |
| US | 2019-0232813 | A1 | 01 August 2019 | CN | 110077269 | A | 02 August 2019 |
| | | | | CN | 110077269 | B | 17 May 2022 |
| | | | | EP | 3517351 | A1 | 31 July 2019 |
| | | | | EP | 3517351 | B1 | 31 March 2021 |
| | | | | JP | 2019-129671 | A | 01 August 2019 |
| | | | | US | 10967753 | B2 | 06 April 2021 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230144699